# EUROPÄISCHE PATENTSCHRIFT

(11) **EP 0 918 450 B1**
(45) Veröffentlichungstag und Bekanntmachung des Hinweises auf die Patenterteilung: **15.12.2004**
(21) Anmeldenummer: 98120452.2
(22) Anmeldetag: 29.10.1998
(51) Int. Cl.: H05K 5/00, E05D 1/02

(54) **Aus Kunststoff hergestelltes Gehäuse für elektrische oder elektronische Bauteile**
Plastic housing for electrical or electronic components
Boîtier plastique pour composants électriques ou électroniques

(30) Priorität: 19.11.1997 DE 29720510 U
(43) Veröffentlichungstag der Anmeldung: 26.05.1999
(73) Patentinhaber: Bernstein AG, 32457 Porta Westfalica (DE)
(72) Erfinder:
(74) Vertreter: Stracke, Alexander, Dipl.-Ing.

(56) Entgegenhaltungen:
- DE-A- 3 447 801
- DE-U- 8 401 081
- US-A- 5 434 362

## Beschreibung

Die vorliegende Erfindung betrifft ein aus Kunststoff hergestelltes Gehäuse für elektrische oder elektronische Bauteile, bestehend aus einem Boden, aus Seitenwänden und einem Deckel.

Der vorliegenden Erfindung liegt die Aufgabe zugrunde, ein Gehäuse der gattungsgemäßen Art zu schaffen, welches preiswert durch die Verwendung einfacher Spritzgußformen herstellbar ist, welches leicht und ohne zusätzliche notwendige Verschlußmittel montierbar und verschließbar ist und darüber hinaus auch noch den Vorteil bietet, daß der Einbau elektrischer oder elektronischer Bauteile in das Gehäuseinnere ohne räumliche Behinderung durch die Seitenwände möglich ist.

Eine Lösung dieser Aufgabe besteht erfindungsgemäß darin, daß der Boden mit den Seitenwänden und der Deckel mit einer der Seitenwände über Filmscharniere verbunden ist, daß die Seitenwände im jeweiligen Eckbereich des Gehäuses untereinander durch Rastmittel miteinander lösbar verbunden sind und daß der Deckel im Bereich der oberen, umlaufenden Stirnkanten der Seitenwände mit zumindest einer dieser Seitenwände ebenfalls durch Rastmittel lösbar verbunden ist.

Eine weitere Lösung der erfindungsgemäßen Aufgabe besteht darin, daß die Seitenwände an ihren unteren und oberen Längskanten durch Rastmittel lösbar mit dem Boden bzw. dem Deckel und im Eckbereich des Gehäuses untereinander ebenfalls durch Rastmittel lösbar miteinander verbunden sind.

Beide erfindungsgemäße Lösungen bringen eine Vielzahl gemeinsamer Vorteile mit sich.

So können in beiden Fällen alle Bestandteile des Gehäuses, nämlich der Boden und der Deckel einerseits sowie die Seitenwände andererseits als plattenförmige Bauteile flachliegend in einer relativ einfachen Werkzeugform gefertigt werden.

Da die einzelnen Bauteile im geschlossenen Zustand des Gehäuses über Rastmittel lösbar miteinander verbunden sind, werden für das Aufbauen und Verschließen des Gehäuses in beiden Fällen keine zusätzlichen Verschlußmittel wie Schrauben, federnd gelagerte Rastbolzen oder dergleichen benötigt, ebenso werden zusätzliche Scharniere erübrigt.

Da die Seitenwände gegenüber dem Boden längs der Filmscharniere abgeklappt oder durch die Rastmittel vollständig vom Boden gelöst werden können, besteht die Möglichkeit, elektrische oder elektronische Bauteile in den Bereich des Gehäuse-Innenraumes einzubauen, ohne dabei durch die Seitenwände behindert oder räumlich beengt zu werden.

Weitere Merkmale und Vorteile der Erfindung ergeben sich aus den Unteransprüchen.

Bevorzugte Ausführungsbeispiele der Erfindung sind in den beigefügten Zeichnungen dargestellt und werden im folgenden näher beschrieben.

Es zeigen:
- Figur 1: eine perspektivische Darstellung eines erfindungsgemäßen Gehäuses im geschlossenen Zustand,
- Figur 2: eine perspektivische Darstellung des Gehäuses gemäß Figur 1 im geöffneten Zustand,
- Figur 3: einen Teilschnitt nach der Linie III-III in Figur 2,
- Figur 4: einen Teilschnitt nach der Linie IV-IV in Figur 3,
- Figur 5: eine Draufsicht auf das vollständig aufgeklappte Gehäuse nach den Figuren 1 und 2,
- Figur 6: einen Schnitt nach der Linie VI-VI in Figur 5, wobei durch gestrichelte Linien die Kontur des aufgerichteten Gehäuses dargestellt ist,
- Figur 7: eine perspektivische Darstellung nach Art eines Sprengbildes betreffend ein Gehäuse nach einem weiteren Ausführungsbeispiel der Erfindung,
- Figur 8: einen Teilschnitt nach der Linie VIII-VIII in Figur 7,
- Figur 9: einen Teilschnitt nach der Linie IX-IX in Figur 7.

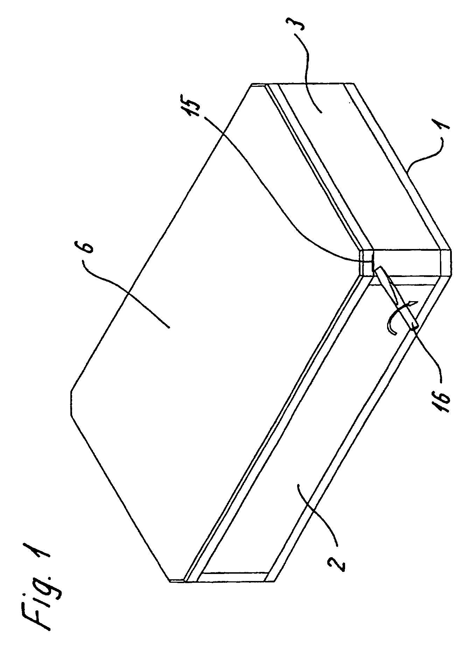

Das in den Figuren 1-6 dargestellte Gehäuse für elektrische oder elektronische Bauteile ist in an sich bekannter Weise aus Kunststoff hergestellt und besteht aus einem Boden 1, aus vier Seitenwänden 2, 3, 4 und 5 sowie einem Deckel 6.

Der Boden 1 ist mit den Seitenwänden 2, 3, 4 und 5 über Filmscharniere 7 gelenkig verbunden. Die Gestaltung bzw. Ausbildung derartiger Filmscharniere 7 bei der Herstellung von Kunststoffteilen ist dem Fachmann hinlänglich bekannt, so daß hier auf weitere Ausführungen zu diesen Filmscharnieren 7 verzichtet werden kann.

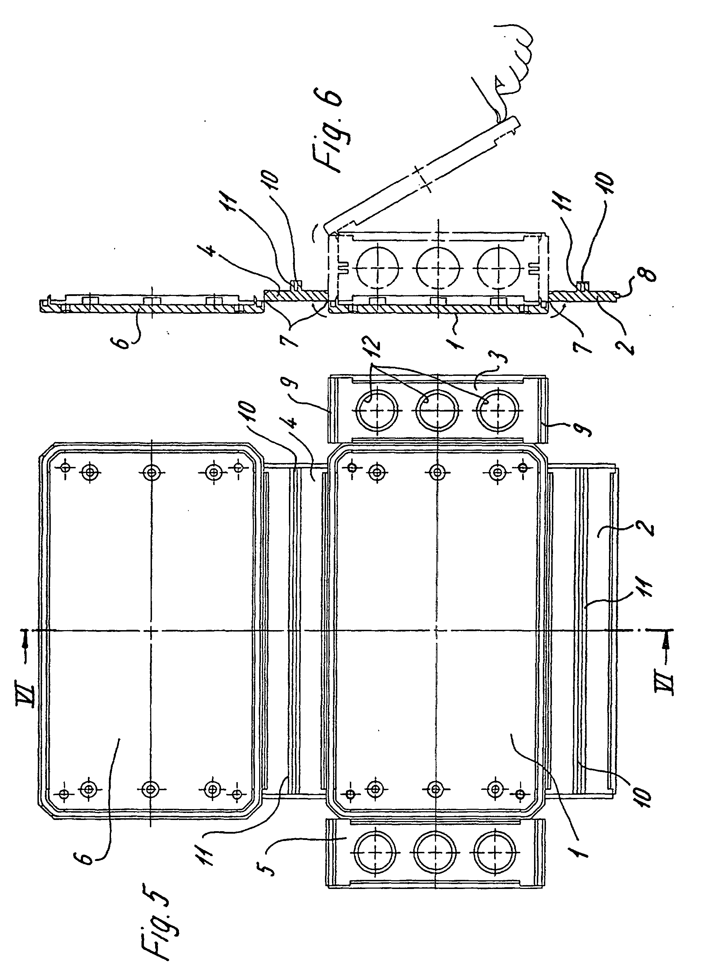

Wie die Figuren 5 und 6 deutlich machen, können der Boden 1 und der Deckel 6 praktisch in eine gemeinsame Ebene fluchtend zueinander aufgeklappt werden, das Gleiche gilt für die Seitenwände 2, 3, 4 und 5.

In dieser in Figur 5 und in Figur 6 gezeigten Position werden die für das Gehäuse benötigten Bauteile fertigungstechnisch hergestellt. Es ist für jeden Fachmann einleuchtend, daß für die Herstellung der in dieser Art flachliegenden Bauteile lediglich einfache Werkzeugformen benötigt werden, so daß die Herstellung der für das Gehäuse benötigten Bauteile äußerst preiswert möglich ist.

Die Seitenwände 2, 3, 4 und 5 sind im jeweiligen Eckbereich des Gehäuses durch Rastmittel lösbar miteinander verbunden, wobei die Rastmittel im dargestellten Ausführungsbeispiel jeweils aus miteinander korrespondierenden Raststegen 8 einerseits und Rastnuten 9 andererseits bestehen.

Der Deckel 6 ist, wie schon erwähnt, mit einer der Seitenwände über ein Filmscharnier 7 gelenkig verbunden. Diese Seitenwand trägt im dargestellten Ausführungsbeispiel das Bezugszeichen 4.

Der Deckel 6 ist im dargestellten Ausführungsbeispiel im Bereich der oberen, umlaufenden Stirnkanten der übrigen Seitenwände 2, 3 und 5 mit diesen ebenfalls durch Rastmittel lösbar verbunden, wobei auch hier die Rastmittel wieder aus miteinander korrespondierenden Raststegen 8 einerseits und Rastnuten 9 andererseits bestehen. Die Rastnuten 9 sind dabei im Deckel 6 und in Raststege 8 an den oberen Stirnkanten der besagten Seitenwände 2, 3 und 5 angebracht.

Es sei an dieser Stelle ausdrücklich darauf hingewiesen, daß für eine sichere Verschlußstellung des Deckels 6 auch eine Verbindung durch Rastmittel mit lediglich einer der Seitenwände 2, 3 und 5 ausreichend sein würde, wobei dann sinnvollerweise die Rastmittel-Verbindung erfolgen sollte im Bereich der dem Filmscharnier 7 zwischen Seitenwand 4 und Deckel 6 gegenüberliegenden Seitenwand 2.

Zweifellos ist aber eine über drei Seiten umlaufende Verbindung zwischen dem Deckel 6 und den Seitenwänden 2, 3 und 5 im Sinne eines dichten Abschlusses des Gehäuses vorzuziehen.

Wie die Figuren 1-6 weiterhin deutlich machen, sind an zwei gegenüberliegenden Seitenwänden 2 und 4 innenseitig parallel zum Boden 1 bzw. zum Deckel 6 verlaufende und jeweils mit einer Längsnut 10 versehene Stege 11 angeformt, wobei die beiden einander gegenüberliegenden Stege 11 den gleichen Abstand zum Boden 1 bzw. zum Deckel 6 aufweisen. Diese angeformten und mit Längsnuten 10 versehenen Stege 11 ermöglichen das Einschieben von Leiterplatten oder ähnlichen Bauteilen in das Innere des Gehäuses.

Weiterhin geht aus den Figuren 1-6 hervor, daß die Seitenwände 3 und 5 mit von der jeweiligen Innenseite ausgehenden Einsenkungen 12 versehen sind, wobei diese Einsenkungen 12 im Bereich der jeweiligen Außenseite durch eine einstückig mit der Seitenwand im übrigen durch Sollbruchstellen 13 verbundene Verschlußklappe 14 begrenzt sind. Das zuletzt Gesagte ergibt sich besonders anschaulich aus der TeilSchnittdarstellung gemäß Figur 3.

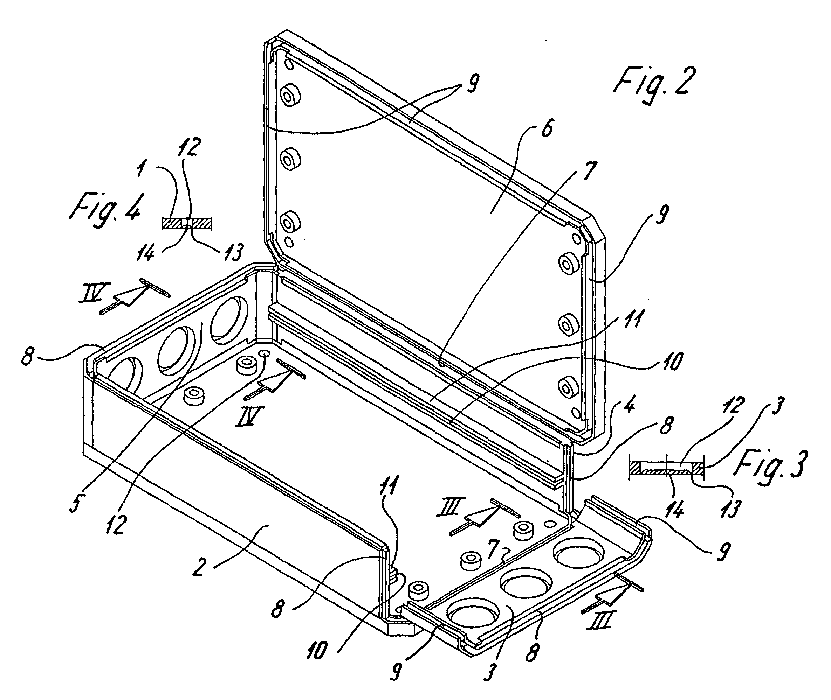

Selbstverständlich kann eine entsprechende Konstruktion mit Einsenkungen 12 auch im Bereich des Bodens 1 oder des Deckels 6 vorgesehen sein, wie Figur 4 besonders anschaulich zeigt. Auch hier werden die entsprechenden Einsenkungen 12 im Bereich der Außenseite des Bodens 1 oder des Deckels 6 durch einstückig angeformte und mit dem Boden 1 oder dem Deckel 6 durch Sollbruchstellen 13 verbundene Verschlußklappen 14 begrenzt.

Diese Einsenkungen 12 stören in keiner Weise das gefällige Äußere des Gehäuses bieten aber bei Bedarf die praktische Möglichkeit, nach dem Entfernen der jeweiligen Verschlußklappen 14 beispielsweise Kabel in das Gehäuse hineinzuführen oder Verbindungsschrauben zur Befestigung des gesamten Gehäuses an beliebigen Halterungen beispielsweise durch den Boden 1 oder den Deckel 6 hindurchzuführen.

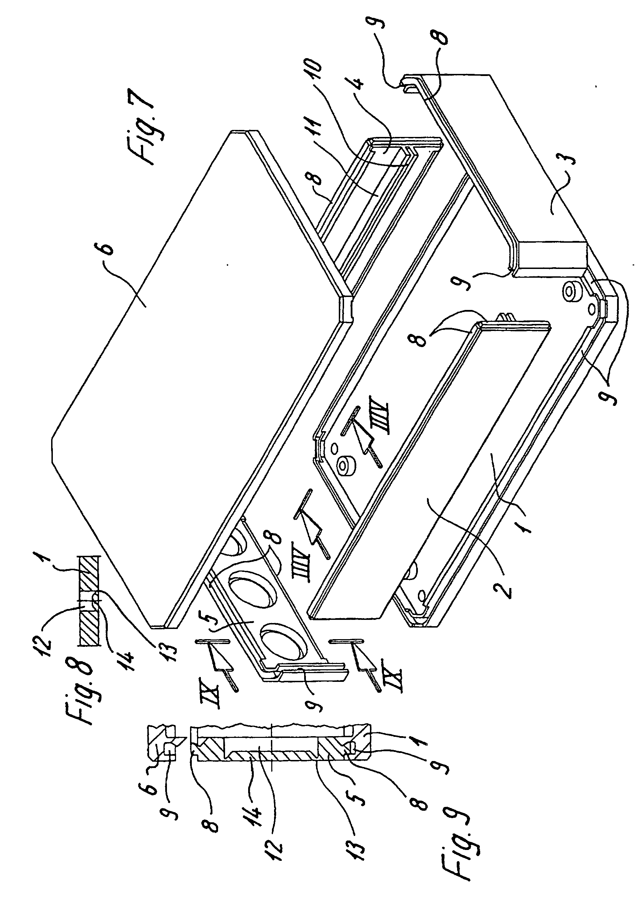

Beim Ausführungsbeispiel der Erfindung gemäß den Figuren 7-9 sind die einzelnen Bestandteile des Gehäuses, nämlich der Boden 1, die Seitenwände 2-5 sowie der Deckel 6, ausschließlich über Rastmittel lösbar miteinander verbunden.

Auch hier finden bevorzugt Rastmittel in Form von miteinander korrespondierenden Raststegen 8 einerseits sowie Rastnuten 9 andererseits Verwendung.

Somit können bei der Gestaltung des Gehäuses entsprechend dem Ausführungsbeispiel nach den Figuren 7-9 die einzelnen Bauteile des Gehäuses vollständig voneinander getrennt und entsprechend auch vollständig unabhängig voneinander gefertigt werden.

Auch bei dieser Ausführungsform können zwei gegenüberliegende Seitenwände, beispielsweise die mit den Bezugszeichen 2 und 4 bezeichneten Seitenwände, mit angeformten und Längsnuten 10 aufweisenden Stegen 11 ausgestattet sein. Ebenso können, was die Figuren 8 und 9 zeigen, sowohl die Seitenwände wie auch der Boden 1 oder der Deckel 6 mit Einsenkungen 12 ausgestattet sein, die lediglich durch über Sollbruchstellen 13 gehaltene Verschlußklappen 14 verschlossen sind, so wie dies schon beim Ausführungsbeispiel nach den Figuren 1-6 ausführlich beschrieben wurde. Insoweit kann auf Wiederholungen zu diesen konstruktiven Details an dieser Stelle verzichtet werden.

Für beide möglichen Gehäusevarianten ist es sinnvoll, so wie in Figur 1 dargestellt, zumindest im Bereich der Verbindungsebene zwischen den Seitenwänden und dem Deckel 6 eine Einstecköffnung 15 für ein einfaches Öffnungswerkzeug, beispielsweise einen Schraubendreher 16, vorzusehen, um bei Bedarf das Gehäuse leicht und bequem durch Überwindung der Rastkräfte öffnen zu können.

## Patentansprüche

1. Aus Kunststoff hergestelltes Gehäuse für elektrische oder elektronische Bauteile, bestehend aus einem Boden, aus Seitenwänden und einem Deckel, **dadurch gekennzeichnet, daß** der Boden (1) mit den Seitenwänden (2, 3, 4, 5) und der Deckel (6) mit einer der Seitenwände (4) über Filmscharniere (7) verbunden ist, daß die Seitenwände (2, 3, 4, 5) im jeweiligen Eckbereich des Gehäuses untereinander durch Rastmittel miteinander lösbar verbunden sind und daß der Deckel (6) im Bereich der oberen, umlaufenden Stirnkante der Seitenwände (2, 3, 5) zumindest mit einer dieser Seitenwände (2, 3, 5) ebenfalls durch Rastmittel lösbar verbunden ist.

2. Aus Kunststoff hergestelltes Gehäuse für elektrische oder elektronische Bauteile, bestehend aus einem Boden, aus Seitenwänden und einem Deckel, **dadurch gekennzeichnet, daß** die Seitenwände (2, 3, 4, 5) an ihren unteren und oberen Längskanten durch Rastmittel lösbar mit dem Boden (1) bzw. dem Deckel (6) und im Eckbereich des Gehäuses untereinander ebenfalls durch Rastmittel lösbar miteinander verbunden sind.

3. Gehäuse nach Anspruch 1 oder 2, **dadurch gekennzeichnet, daß** die Rastmittel jeweils aus miteinander korrespondierenden Raststegen (8) und Rastnuten (9) bestehen.

4. Gehäuse nach einem oder mehreren der vorhergehenden Ansprüche, **dadurch gekennzeichnet, daß** zumindest im Bereich der Verbindungsebene zwischen dem Deckel (6) und den Seitenwänden (2, 3, 4, 5) eine Einstecköffnung (15) für ein einfaches Öffnungswerkzeug wie z. B. einen Schraubendreher (16), vorgesehen ist.

5. Gehäuse nach einem oder mehreren der vorhergehenden Ansprüche, **dadurch gekennzeichnet, daß** zumindest eine Seitenwand (2, 3, 4, 5) und/oder der Boden (1) bzw. der Deckel (6) mit zumindest einer von der Innenseite ausgehenden Einsenkung (12) versehen ist, die im Bereich der jeweiligen Außenseite durch eine einstückig mit der Seitenwand oder dem Boden bzw. dem Deckel durch Sollbruchstellen (13) verbundene Verschlußklappe (14) begrenzt ist.

6. Gehäuse nach einem oder mehreren der vorhergehenden Ansprüche, **dadurch gekennzeichnet, daß** an den Innenseiten zweier gegenüberliegender Seitenwände (2, 4) mindestens jeweils ein mit einer Längsnut (10) versehener und parallel zum Boden (1) bzw. zum Deckel (6) verlaufender Steg (11) angeformt ist, wobei die beiden einander gegenüberliegenden Stege (11) in einem gleichen Abstand zum Boden (1) oder zum Deckel (6) angeordnet sind.

## Claims

1. Plastic housing for electrical or electronic components, comprising a base, side walls and a lid, **characterized in that** the base (1) is connected to the side walls (2, 3, 4, 5), and the lid (6) is connected to one of the side walls (4), via film hinges (7), **in that** the side walls (2, 3, 4, 5) are detachably interconnected in the respective corner region of the housing by latching means, and **in that** the lid (6) is detachably connected, likewise by latching means, at least to one of the side walls (2, 3, 5) in the region of the upper, peripheral end edge of these side walls (2, 3, 5).

2. Plastic housing for electrical or electronic components, comprising a base, side walls and a lid, **characterized in that**, at their lower and upper longitudinal edges, the side walls (2, 3, 4, 5) are detachably connected to the base (1) and to the lid (6) respectively by latching means, and are detachably interconnected, likewise by latching means, in the corner region of the housing.

3. Housing according to Claim 1 or 2, **characterized in that** the latching means each comprise mutually corresponding latching webs (8) and latching grooves (9).

4. Housing according to one or more of the preceding claims, **characterized in that** an insertion opening (15) for a simple opening tool, such as, for example, a screwdriver (16), is provided at least in the region of the connection plane between the lid (6) and the side walls (2, 3, 4, 5).

5. Housing according to one or more of the preceding claims, **characterized in that** at least one side wall (2, 3, 4, 5) and/or the base (1) or the lid (6) is provided with at least one depression (12) which originates from the inside and is bounded in the region of the respective outer side by a closure flap (14) integrally connected to the side wall or the base or the lid by means of predetermined breaking points (13).

6. Housing according to one or more of the preceding claims, **characterized in that** at least one web (11) provided with a longitudinal groove (10) and running parallel to the base (1) or to the lid (6) is integrally formed on each of the inner sides of two opposite side walls (2, 4), the two mutually opposite webs (11) being arranged at an equal distance from the base (1) or from the lid (6).

## Revendications

1. Boîtier en matière plastique pour composants électriques ou électroniques, formé par un fond, des parois latérales et un couvercle, **caractérisé en ce que** le fond (1) est relié aux parois latérales (2, 3, 4, 5) et le couvercle (6) est relié à l'une des parois latérales (4) par des films formant charnières (7), **en ce que** les parois latérales (2, 3, 4, 5) sont assemblées les unes aux autres de manière amovible par des moyens d'encliquetage dans chaque zone de coin du boîtier et **en ce que** le couvercle (6), dans la zone des bords frontaux supérieurs périphériques des parois latérales (2, 3, 5), est assemblé de manière amovible avec au moins une de ces parois latérales (2, 3, 5) également par des moyens d'encliquetage.

2. Boîtier en matière plastique pour composants électriques ou électroniques, formé par un fond, des parois latérales et un couvercle, **caractérisé en ce que** les parois latérales (2, 3, 4, 5) sont assemblées de manière amovible par des moyens d'encliquetage au niveau de leurs bords longitudinaux inférieurs et supérieurs respectivement avec le fond (1) et le couvercle (6) et sont assemblées les unes aux autres dans les zones de coin du boîtier également de manière amovible par des moyens d'encliquetage.

3. Boîtier selon la revendication 1 ou 2, **caractérisé en ce que** les moyens d'encliquetage sont formés respectivement par des languettes d'encliquetage (8) et des rainures d'encliquetage (9) correspondant entre elles.

4. Boîtier selon une ou plusieurs des revendications précédentes, **caractérisé en ce que**, au moins dans la zone du plan d'assemblage entre le couvercle (6) et les parois latérales (2, 3, 4, 5), il est prévu un orifice d'introduction (15) pour un outil d'ouverture simple, tel qu'un tournevis (16).

5. Boîtier selon une ou plusieurs des revendications précédentes, **caractérisé en ce qu'**au moins une paroi latérale (2, 3, 4, 5) et/ou le fond (1) ou le couvercle (6) sont munis d'au moins un creux (12) partant de la face intérieure, lequel est délimité dans la zone de la face extérieure correspondante par un rabat de fermeture (14) relié d'un seul tenant par des zones de rupture théorique (13) avec la paroi latérale ou le fond ou le couvercle.

6. Boîtier selon une ou plusieurs des revendications précédentes, **caractérisé en ce qu'**une barrette (11), munie d'une rainure longitudinale (10) et s'étendant parallèlement au fond (1) et au couvercle (6), est formée contre les faces intérieures de deux parois latérales (2, 4) face à face, les deux barrettes (11) face à face étant agencées à même distance du fond (1) ou du couvercle (6).
